# EUROPÄISCHE PATENTSCHRIFT

(11) **EP 1 765 545 B1**
(45) Veröffentlichungstag und Bekanntmachung des Hinweises auf die Patenterteilung: **14.10.2009**
(21) Anmeldenummer: 05760759.0
(22) Anmeldetag: 07.07.2005
(51) Int. Cl.: B23K 20/10, H01R 43/02

(54) **ANORDNUNG ZUM VERSCHWEISSEN VON WERKSTÜCKEN MITTELS EINER ULTRASCHALLSCHWEISSVORRICHTUNG**
ARRANGEMENT FOR WELDING WORKPIECES BY MEANS OF AN ULTRASONIC WELDING DEVICE
ENSEMBLE POUR LE SOUDAGE DE PIECES AU MOYEN D'UN DISPOSITIF DE SOUDAGE PAR ULTRASONS

(30) Priorität: 09.07.2004 DE 102004033575
(43) Veröffentlichungstag der Anmeldung: 28.03.2007
(73) Patentinhaber: Schunk Sonosystems GmbH, 35435 Wettenberg (DE)
(72) Erfinder: STEINER, Ernst, 35452 Heuchelheim (DE); DIETERLE, Horst, 35096 Niederweimar (DE); STROH, Dieter, 35435 Wettenberg (DE); STROH, Heiko, 35435 Wettenberg (DE); WAGNER, Peter, 35435 Wettenberg (DE)
(74) Vertreter: Stoffregen, Hans-Herbert
(86) Internationale Anmeldenummer: PCT/EP2005/007346
(87) Internationale Veröffentlichungsnummer: WO 2006/005509

(56) Entgegenhaltungen:
- WO-A-02/43915
- DE-A1- 19 540 860
- US-A- 4 869 419
- US-A- 6 079 608
- US-B1- 6 299 052

## Beschreibung

Die Erfindung bezieht sich auf eine Anordnung zum Verschweißen von Werkstücken wie elektrischen Leitern, insbesondere Litzen, mittels einer Ultraschallschweißvorrichtung umfassend einen die Werkstücke aufnehmenden Verdichtungsraum, der von Abschnitten einer Ultraschallschwingungen übertragenden Sonotrode und einer Gegenelektrode, einem eine senkrecht zu den Abschnitten der Sonotrode und der Gegenelektrode sich erstreckende erste Begrenzungsfläche aufweisenden Begrenzungselement sowie einem zu der ersten Begrenzungsfläche verstellbaren eine zweite Begrenzungsfläche aufweisenden Schieberelement begrenzt ist, wobei die Werkstücke bei geöffnetem Verdichtungsraum in einen Einlegeraum einbringbar sind, der zumindest von den Abschnitten der Sonotrode und der ersten Begrenzungsfläche des Begrenzungselements begrenzt ist.

Eine entsprechende Anordnung ist der US-B-6,299,052 zu entnehmen. Dabei wird der Einlegeraum von der Sonotrode, dem Begrenzungselement sowie dem Schieberelement begrenzt. Das Schieberelement wird zu dem Begrenzungselement beim Einlegen der Leiter derart eingestellt, dass diese im Wesentlichen parallel zueinander und in vertikalen Reihen zueinander ausgerichtet sind. Dies führt insbesondere dann zu erheblichen Nachteilen, wenn wenige Leiter verschweißt werden sollen, da in diesem Fall der Abstand zwischen dem Schieberelement und der ersten Begrenzungsfläche des Begrenzungselementes sehr gering ist, so dass das Einlegen der Leiter zu Problemen führen kann.

Die zum Verschweißen der Leiter vorbekannte Vorrichtung entspricht der der DE-C-37 19 083. Die Funktion der Gegenelektrode übt dabei ein als Querhaupt bezeichneter Abschnitt eines mehrteiligen Ambosses aus, wobei das Querhaupt seinerseits verschiebbar von dem die erste Begrenzungsfläche aufweisenden Begrenzungselement ausgeht, das senkrecht zu dem Abschnitt bzw. der Fläche der Sonotrode verstellbar ist, auf dem die Leiter zum Verschweißen aufliegen.

Zum Verschweißen von Litzen mittels-Ultraschall sind nach der DE-C-44 06 337, DE-A-195 40 860 und US-A-4,782,990 in ihrer Höhe und Breite verstellbare Verdichtungsräume vorgesehen, um eine Anpassung an unterschiedliche, Leiterquerschnitte zu ermöglichen. Dabei ist nach dem zuletzt genannten Dokument die Vorrichtung als Handschweißgerät ausgebildet.

Eine Ultraschallschweißvorrichtung nach dem DE-U-90 01 070 sieht einen Verdichtungsraum vor, der zwei außenseitig rampenförmig verlaufende Seitenschieber aufweist, zwischen denen eine Arbeitsfläche einer Sonotrode verschiebbar angeordnet ist.

Der vorliegenden Erfindung liegt die Aufgabe zugrunde, eine Anordnung der eingangs genannten Art so weiterzubilden, dass ein gezieltes Einbringen bzw. Anordnen von zu verschweißenden Leitern in den Einlegeraum möglich ist, wobei der Verdichtungsraum in einem Umfang geöffnet werden kann, dass das Einlegen nicht behindert wird.

Erfindungsgemäß wird die Aufgabe im Wesentlichen dadurch gelöst, dass der Einlegeraum des Weiteren von einem mit einem Leitabschnitt entlang der ersten Begrenzungsfläche des Begrenzungselementes verlaufenden Leitelement begrenzt ist, wobei der Abstand des Leitabschnitts des Leitelementes zu der ersten Begrenzungsfläche kleiner als Abstand zwischen dieser und der zweiten Begrenzungsfläche des Schieberelementes bei geöffnetem Verdichtungsraum ist. Nach einer alternativen Lösung wird der Einlegeraum von zwei Schenkeln eines Leitelementes oder Abschnitten dieser begrenzt, die sich zumindest abschnittsweise entlang sowohl der ersten Begrenzungsfläche als auch der zweiten Begrenzungsfläche erstrecken, wobei wirksamer Abstand zwischen den Schenkeln bzw. deren Abschnitten kleiner als Abstand zwischen der ersten und zweiten Begrenzungsfläche bei geöffnetem Verdichtungsraum ist. Dabei kann das Leitelement derart geformt sein, dass ein die Schenkel verbindender Querschenkel oberhalb des den Verdichtungsraum begrenzenden Abschnitts der Sonotrode verläuft, also Bodenbegrenzung des Einlegeraums bildet. Alternativ kann der Querschenkel unterhalb des Abschnitts der Sonotrode verlaufen, so dass dieser die Bodenbegrenzung des Einlegeraums ist.

Mit anderen Worten wird einer Ultraschallschweißvorrichtung ein Hilfselement zugeordnet, das beim Einlegen der zu verschweißenden Werkstücke, insbesondere der elektrischen Leiter wie Litzen, derart bei geöffnetem Verdichtungsraum zu der Sonotrode und dem Begrenzungselement bzw. dem Schieberelement ausrichtbar ist, dass die Leiter im gewünschten Umfang zueinander orientiert werden, dass also beim nachfolgenden Schweißprozess ein ordnungsgemäßes und reproduzierbares Verschweißen sichergestellt ist.

Abweichend von der vorbekannten Lösung wird der Einlegeraum nicht oder nicht ausschließlich von den Elementen begrenzt, die den Verdichtungsraum umgeben. Vielmehr wird bei zurückgezogenem Schieberelement der verbleibende Raum durch das Leitelement eingeengt, ohne dass das Einlegen der Leiter durch das Schieberelement und das Begrenzungselement behindert wird, die einen hinreichenden Abstand zueinander aufweisen. Gleichzeitig werden jedoch die zu verschweißenden Leiter im gewünschten Umfang zueinander ausgerichtet, die in senkrecht oder nahezu senkrecht zur von der Sonotrode gebildeten Schweißfläche sich erstreckenden Reihen eingebracht werden, sich also nicht kreuzen, wodurch die Schweißergebnisse beeinträchtigt werden würden.

Das Leitelement selbst ist als ein beim Schließen des Verdichtungsraums wegbiegbares bzw. verstellbares Element ausgebildet, so dass der eigentliche Schweiß- bzw. vorausgehende Verdichtungsvorgang nicht behindert wird.

Das Leitelement ist vorzugsweise als ein streifenförmiges Federblech ausgebildet, damit beim Einlegen der Leiter eine hinreichende Nachgiebigkeit sichergestellt ist.

So kann das Leitelement ein zumindest zwei Schenkel aufweisendes gebogenes Federblech sein, wobei einer der Schenkel insbesondere entlang Verstellweg des Begrenzungselementes verlaufen kann und der andere Schenkel der sich entlang der ersten Begrenzungsfläche erstreckende Leitabschnitt ist.

Um das Federblech ordnungsgemäß zu fixieren, jedoch Einbußen bezüglich der Beweglichkeit des Leitelements nicht in Kauf nehmen zu müssen, sieht eine Weiterbildung der Erfindung vor, dass das Federblech einen Halteschenkel und einen senkrecht zu diesem verlaufenden ersten Innenschenkel umfasst, der in den entlang des Verstellwegs des Schiebeelementes verlaufenden Schenkel als zweiten Innenschenkel und den zumindest abschnittsweise sich senkrecht zu diesem und entlang der ersten Begrenzungsfläche verlaufenden Schenkel als den Leitabschnitt übergeht.

Der Halteschenkel und der erste und der zweite Innenschenkel weisen dabei vorzugsweise die Geometrie eines ungleichschenkligen U's auf, wobei dieses unter Einbeziehung des Leitabschnitts ein offenes Viereck ergeben sollte.

Insbesondere sollte das Federblech zumindest drei Schenkel umfassen, von denen einer als der Leitabschnitt ausgebildet ist, ein sich angrenzender Schenkel parallel zur von der Sonotrode gebildeten Begrenzungsfläche verläuft und ein dritter Schenkel als Halteschenkel ausgebildet ist oder in einen solchen zu dem dritten Schenkel abgewinkelten Halteschenkel übergeht. Umfasst das Federblech drei Schenkel, so sollten diese in unbelastetem Zustand die Geometrie eines ungleichschenkligen U's bilden, wobei der parallel zu dem Leitabschnitt verlaufende dritte Schenkel zum Fixieren des Federblechs dient.

Das Halteelement selbst geht von der Ultraschallschweißvorrichtung aus und sollte sich entlang einer Außenfläche des Schieberelementes erstrecken, die sowohl senkrecht zu dem Abschnitt der Sonotrode als auch zu der ersten Begrenzungsfläche verläuft. Um ein sicheres Führen der einzubringenden Leiter sicherzustellen, kann entlang jeder entsprechenden Seitenaußenfläche des Schieberelementes ein entsprechendes Leitelement vorgesehen sein.

Ferner sollte der Leitabschnitt des Leitelements bei geöffnetem Verdichtungsraum sich über eine Länge entlang der ersten Begrenzungsfläche erstrecken, die größer als wirksame Länge der ersten Begrenzungsfläche bei geschlossenem Verdichtungsraum ist.

Um das Einbringen der zueinander auszurichtenden Werkstücke wie Litzen zusätzlich zu erleichtern, sieht eine Weiterbildung der Erfindung vor, dass der auch als Führungsschenkel zu bezeichnende Leitabschnitt zumindest abschnittsweise unter einem Winkel α geneigt zu der ersten Begrenzungsfläche verläuft, und zwar zumindest in dem Bereich, der in den zweiten Innenschenkel übergeht. Dabei kann der Winkel α sich belaufen zwischen vorzugsweise 15° und vorzugsweise 60°, um nur beispielhaft Zahlenwerte zu nennen.

Ist bevorzugterweise das Leitelement ortsfest fixiert und wird beim Verschweißen der Werkstücke weggebogen, so sieht eine Weiterbildung der Erfindung vor, dass das Leitelement verstellbar wie verschwenkbar ist. Hierzu kann zum Beispiel das Leitblech bzw. der Halteschenkel von einem Kolben eines Druckzylinders ausgehen, um das Leitelement beim Schließen des Verdichtungsraums wegzuziehen.

Nach dem Stand der Technik ist es bekannt, dass das Schieberelement über einen Anschlag in seiner Bewegungsrichtung in Richtung der ersten Begrenzungsfläche begrenzt wird, um so den Verdichtungsraum in seiner Breite vorzugeben. Der hierzu verwendete Antrieb zum Einstellen des Anschlages kann erfingdungsgemäß derart genutzt werden, dass das Leitelement mit dem Antrieb verbindbar ist, so dass infolgedessen eine Ausrichtung des Leitabschnitts bzw. Führungsschenkels auf die erste Begrenzungsfläche in Abhängigkeit von der Anzahl der zu verschweißenden Werkstücke erfolgen kann, die wiederum die Breite des Verdichtungsraums und damit die Position des Anschlags für das Schiebeelement vorgeben. Bei dem Antrieb für den Anschlag und damit des Leitelementes handelt es sich insbesondere um einen Spindelantrieb.

Ist das Leitelement vorzugsweise ein gebogenes Federblech, so sieht eine Alternative vor, dass das Leitelement ein entlang zumindest einer sich entlang des Verstellwegs des Schieberelementes erstreckenden Außenfläche des Schiebeelementes flächiges Blechelement ist, das eine Ebene aufspannt, die parallel oder in etwa parallel zu der Außenfläche und senkrecht oder in etwa senkrecht zu dem Abschnitt der Sonotrode verläuft, wobei das Blechelement mit dem Schieberelement verbunden und relativ zu diesem verstellbar ist. Dabei kann das Blechelement mit einem Federelement in Wirkverbindung stehen, über das das Blechelement relativ zu dem Schiebeelement in Richtung der ersten Begrenzungsfläche verstellbar ist.

Um den Abstand zwischen Federblech und erster Begrenzungsfläche und somit die Breite des Einlegeraums einstellen zu können, sieht eine Weiterbildung der Erfindung vor, dass das in Richtung der ersten Begrenzungsfläche federkraftbeaufschlagte Federblech zu einem verstellbaren Anschlag bewegbar ist, dessen Position auf die Breite des Einlegeraums abgestimmt ist. Alternativ bestünde die Möglichkeit, das Federblech mit einem Antrieb zu verbinden, um das Federblech zu der ersten Begrenzungsfläche im gewünschten Umfang und somit die Breite des Einlegeraums einstellen zu können.

Insbesondere ist vorgesehen, dass das Blechelement zumindest ein parallel zum Verstellweg verlaufendes Langloch aufweist, in das ein von dem Schieberelement ausgehender Vorsprung wie Stift eingreift. Zum sicheren Führen sind insbesondere zwei Langlöcher vorgesehen, in die jeweils ein von dem Schieberelement ausgehender Vorsprung eingreift. Durch diese Maßnahmen ist sichergestellt, dass bei geöffnetem Verdichtungsraum das Blechelement mit seinem Leitabschnitt im gewünschten Umfang in Richtung der ersten Begrenzungsfläche des Schieberelementes verstellt ist, ohne dass das Einlegen der Werkstücke durch das Schieberelement selbst behindert wird. Wird sodann das Schieberelement beim Schließen des Verdichtungsraums in Richtung der ersten Begrenzungsfläche bewegt, so kann relativ hierzu das Leitelement bewegt werden, so dass eine Behinderung nicht erfolgt.

Das Leitblech selbst weist vorzugsweise eine Rechteckform mit ersten und zweiten entlang des Verstellwegs verlaufenden Längsschenkeln und diese verbindendem sich entlang der ersten Begrenzungsfläche verlaufenden Querschenkel als der Leitabschnitt auf. Dabei ist zum einfachen Einlegen der Übergangsbereich zwischen einlegeraumöffnungsseitigem Längsschenkel und Querschenkel angeschrägt.

Um beim Zurückfahren des Schieberelementes den Einlegeraum zunächst zu vergrößern, sieht eine Weiterbildung vor, dass von dem Schieberelement ein in das Blechelement oder in ein von diesem ausgehendes Element wie Klinke eingreifender Mitnehmer ausgeht, wobei der Mitnehmer und das Element dann in Eingriff stehen, wenn das Schieberelement von der ersten Begrenzungsfläche wegbewegt wird.

Auch wenn es grundsätzlich ausreichen würde, dass nur entlang einer der Außenflächen des Schieberelementes ein entsprechendes Blechelement verstellbar zu diesem angeordnet ist, so ist bevorzugterweise vorgesehen, dass entlang jeder senkrecht oder in etwa senkrecht zu dem Abschnitt der Sonotrode verlaufenden Außenflächen des Schieberelementes ein Leitelement angeordnet ist.

Weitere Einzelheiten, Vorteile und Merkmale der Erfindung ergeben sich nicht nur aus den Ansprüchen, den diesen zu entnehmenden Merkmalen -für sich und/oder in Kombination-, sondern auch aus der nachfolgenden Beschreibung von der Zeichnung zu entnehmenden bevorzugten Ausführungsbeispielen.

Es zeigen:
- Fig. 1: eine Vorderansicht eines Verdichtungsraums einer Ultraschallschweißvorrichtung,
- Fig. 2: der Verdichtungsraum gemäß Fig. 1 mit einer abweichenden Anzahl von zu verschweißenden Leitern,
- Fig. 3: der Verdichtungsraum gemäß Fig. 1 in Draufsicht,
- Fig. 4: eine alternative Ausführungsform eines Leitblechs für einen Verdichtungsraum entsprechend der Fig. 1 - 3,
- Fig. 5: eine Ausgestaltung eines auf einen Verdichtungsraum gemäß den Fig. 1 - 4 auszurichtenden Leitelementes,
- Fig. 6: eine alternative Ausführungsform zu der der Fig. 5,
- Fig. 7: eine weitere Ausführungsform eines zu einem Verdichtungsraum gemäß der Fig. 1 - 5 verstellbaren Leitelementes,
- Fig. 8: eine weitere Ausführungsform eines einem Verdichtungsraum zugeordneten Leitelementes,
- Fig. 9: eine der Fig. 8 entsprechende Darstellung, jedoch mit einer größeren Anzahl von Leitern,
- Fig. 10: eine Prinzipdarstellung einer Ultraschallschweißvorrichtung mit Peripherie,
- Fig. 11-13: einen den Darstellungen gemäß Fig. 1 - 3 entsprechenden Verdichtungsraum mit einer alternativen Ausführungsform eines Leitelements,
- Fig. 14: eine alternative Ausführungsform zu der Anordnung gemäß Fig. 8 und 9,
- Fig. 15: eine weitere Ausführungsform eines einem Verdichtungsraum zugeordneten Leitelements und
- Fig. 16: eine alternative Ausgestaltung des Leitelements nach Fig. 15.

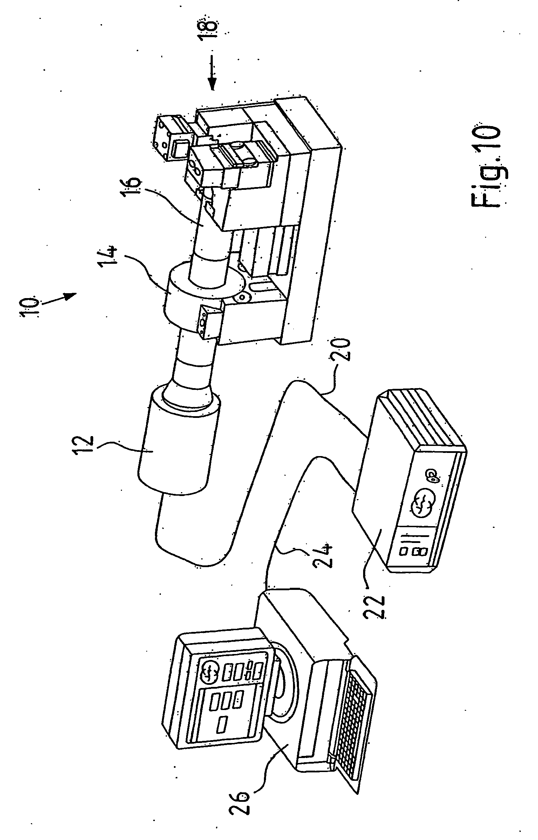

Der Fig. 10 ist rein prinzipiell eine Anordnung zu entnehmen, mit der Werkstücke wie insbesondere elektrische Leiter bzw. Litzen zu Knoten verschweißt werden sollen. Hierzu ist eine Ultraschallschweißvorrichtung oder -maschine 10 vorgesehen, die in gewohnter Weise einen Konverter 12, gegebenenfalls einen Booster 14 sowie eine Sonotrode 16 umfasst. Die Sonotrode 16 bzw. eine dieser zugeordnete und nachstehend näher erläuterte Gegenelektrode begrenzen einen Verdichtungsraum 18, wie dieser zum Beispiel in der US-A-4,596,352, US-A-4,869,419 oder DE-C-37 19 083 beschrieben worden ist. Der Verdichtungsraum 18 ist dabei in Höhe und Breite verstellbar, um diesen in seinem Querschnitt auf die Anzahl bzw. den Querschnitt der zu verschweißenden Leiter einstellen zu können. Der Konverter 12 wird über eine Leitung 20 mit einem Generator 22 verbunden, der seinerseits über eine Leitung 24 mit einem Rechner 26 verbunden ist, um Schweißparameter bzw. Querschnitt von zu verschweißenden Leitern einzugeben. Die Leistungsabgabe des Generators 22 kann sodann bestimmt werden, um mittels eines in dem Rechner 26 abgespeicherten Programms die erforderlichen Schweißparameter abzurufen und entsprechend mittels des Konverters 12 Ultraschallschwingungen zu erzeugen, die über den Booster 14 verstärkt auf die Sonotrode 16 bzw. deren Schweißfläche übertragen werden.

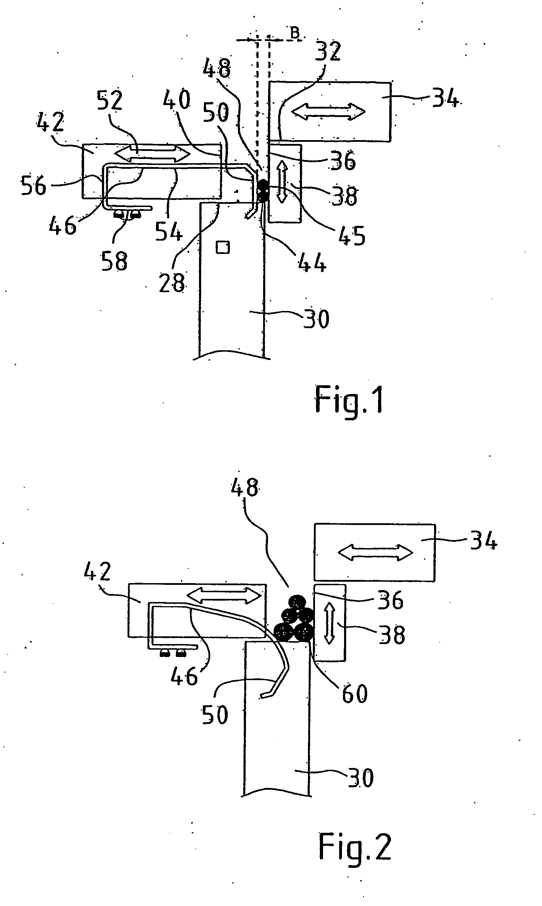

Den Fig. 1 - 9 sind die wesentlichen Elemente des im Querschnitt verstellbaren, also in den Ausführungsbeispielen in Höhe und Breite verstellbaren Verdichtungsraums 18 zu entnehmen. Der Verdichtungsraum 18 wird dabei von einem die Schweißfläche bildenden Abschnitt 28 der Sonotrode 16 bzw. deren Kopf 30, von einem dem Abschnitt 28 des Sonotrodenkopfs 30 gegenüberliegenden Abschnitt 32 einer Gegenelektrode 34, einem senkrecht zu dem Abschnitt 28 des Sonotrodenkopfs 30 verstellbaren eine erste Begrenzungsfläche 36 zur Verfügung stellenden Begrenzungselement 38 sowie einem eine zweite Begrenzungsfläche 40 aufweisendem als Seitenschieber 42 zu bezeichnenden Schieberelement begrenzt. Zum Verschweißen wird der Verdichtungsraum 18 geschlossen, so dass der Sonotrodenkopf 30, die Gegenelektrode 34, das Begrenzungselement 30 und der Seitenschieber 42 mit ihren Abschnitten bzw. Flächen 28, 32, 36, 40 in Kontakt mit zu verschweißenden Werkstücke wie Leitern 44, 45 stehen und diese somit verdichtet und verschweißt werden können.

Um eine ordnungsgemäße Verschweißung insbesondere zu einem Knoten zu gewährleisten, hat sich gezeigt, dass die zu verschweißenden Leiter 44, 45 in dem Verdichtungsraum 18 parallel zueinander ausgerichtet und übereinander angeordnet sein sollten. Dies ist prinzipiell der Fig. 1 zu entnehmenden, in der die zu verschweißenden zwei Leiter 44, 45 übereinander und parallel zueinander ausgerichtet sind.

Um ungeachtet dessen den Verdichtungsraum 18 im hinreichenden Umfang öffnen zu können, also einen hinreichend großen Abstand zwischen dem Begrenzungselement 38 und dem Seitenschieber 42, d.h. deren Begrenzungsflächen 36, 40 einstellen zu können, um das Einlegen der Leiter 44, 45 nicht zu behindern bzw. zu erschweren, ist erfindungsgemäß vorgesehen, dass über ein in den Ausführungsbeispielen der Fig. 1 - 7 als gebogenes Federblech 46 ausgebildetes Leitelement ein Einlegeraum 48 zur Verfugung gestellt wird, dessen Breite B auf einen Querschnittsbereich der zu verschweißenden und übereinander angeordneten Leiter 44, 45 ausgelegt ist. Dabei kann das Federblech 46 von einem Gehäuseabschnitt der Ultraschallschweißvorrichtung ausgehen.

Das Federblech 46 weist im Ausführungsbeispiel die Geometrie eines offenen Vierecks auf, wobei freier, nicht festgelegter Außenschenkel 50 entlang der von dem Begrenzungselement 38 zur Verfuegung gestellten ersten Begrenzungsfläche 36 verläuft. Der auch als Leit- oder Führungsschenkel oder. -abschnitt zu bezeichnende Außenschenkel 50 geht in einen entlang des durch einen Doppelpfeil 52 symbolisierten Verstellwegs des Seitenschiebers 42 verlaufenden Innenschenkel 54 über, der seinerseits in einen weiteren vorzugsweise um 90° abgewinkelten Innenschenkel 56 übergeht, der zu einem senkrecht hierzu verlaufenden Halteschenkel 58 führt, über den das Federblech 46 fixiert ist. Somit bilden der Halteschenkel 58 und die Innenschenkel 54, 56 ein U mit ungleichlangen Seitenschenkel. Durch eine diesbezügliche Geometrie weist das Federblech 46 eine hinreichende Flexibilität im Bereich des Außenschenkels 50 senkrecht zu dem Halteschenkel 58 bei gleichzeitiger Stabilität in Richtung des entlang des Verstellwegs 52 verlaufenden Innenschenkels 54 auf, wodurch das gewünschte gezielte Einlegen der Leiter 44, 45 in den von dem Außenschenkel 50 und der ersten Begrenzungsfläche 36 seitlich begrenzten Einlegeraum 48 sichergestellt ist.

Durch die Geometrie eines offenen Viérecks weist das Federelement 46 eine Flexibilität zuvor beschriebener Art auf, die es ermöglicht, dass dann, wenn bei eingestellter Breite des Einlegeraums 48 mehr Leiter 60 eingelegt werden, als der Abstand zwischen dem Leit- oder Führungsschenkel 50 und der ersten Begrenzungsfläche 36 des Begrenzungselements 38 zulässt, das Federelement 46 weggedrückt wird, wie dies anhand der Fig. 2 erläutert wird. Ungeachtet dessen werden die zuerst eingebrachten Leiter übereinander gestapelt, also in Reihen ausgerichtet, wie dies der Fig. 1 zu entnehmen ist, um sodann nach weggedrücktem Federblech 46 eine weitere gewünschte Ausrichtung der Leiter 60 zu ermöglichen, wodurch ein ordnungsgemäßes Verschweißen, zu einem Knotenpunkt sichergestellt wird.

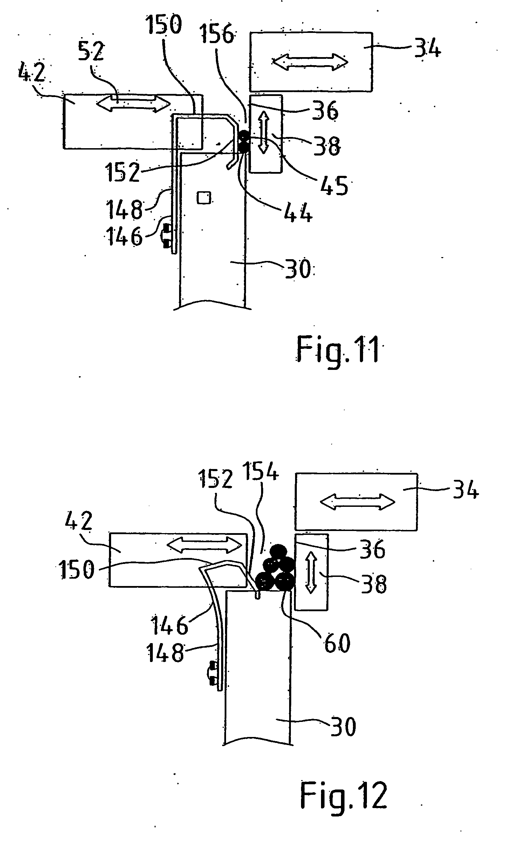

Eine den Fig. 1 - 3 entsprechende Anordnung ist den Fig. 11 - 13 zu entnehmen, so dass für gleiche Elemente gleiche Bezugszeichen verwendet werden. Allerdings weist das Leitelement ebenfalls in Form eines gebogenen Federblechs nicht die Geometrie eines offenen Vierecks, sondern die eines ungleichschenkligen U's auf. So umfasst das Federblech 146 einen lang gestreckten Halteschenkel - 148, einen in unbelastetem Zustand hierzu senkrecht verlaufenden inneren Schenkel 150 und einen hierzu vorzugsweise um 90° abgewinkelten entlang der ersten Begrenzungsfläche 36 verlaufenden Führungs- oder Leitschenkel 152 auf, dessen Abstand zu der ersten Begrenzungsfläche 36 die Breite des Einlegeraums 156 vorgibt, um die Leiter 44, 45 im gewünschten Umfang zueinander ausgerichtet einzubringen. Ist die Anzahl der in den Einlegeraum 156 einzubringenden Leiter bzw. der entsprechende Querschnittsbereich größer als der durch den Abstand zwischen dem Leitschenkel 152 und der ersten Begrenzungsfläche 36 vorgegebene Querschnitt, so wird der Führungsschenkel 152 von dem Sonotrodenkopf 30 in Richtung des Seitenschiebers 42 weggebogen, so dass ein Einlegeraum 154 sich ausbildet, dessen Querschnitt trapezartig ist. Hierdurch werden die Leiter 60 ebenfalls im gewünschten Umfang in den Einlegeraum 154 zueinander ausgerichtet. Gleichzeitig wird der Außenschenkel 148, über den das Federelement 146 fixiert ist, von dem Sonotrodenkopf 30 weggebogen, wie sich unmittelbar aus der Fig. 12 ergibt.

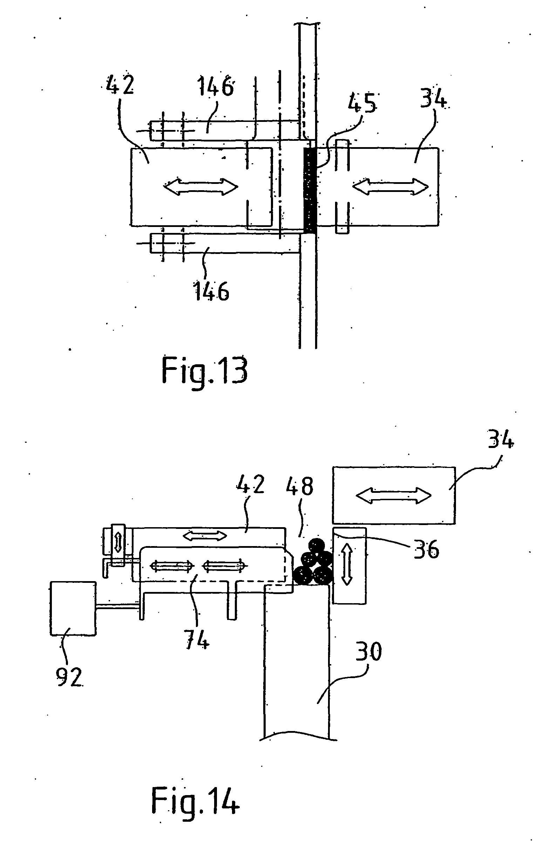

Aus der Draufsicht gemäß Fig. 13 ergibt sich des Weiteren, dass entlang gegenüberliegender Außenflächen des Seitenschiebers 42 jeweils ein den Fig. 11 und 12 entsprechendes Federelement angeordnet ist, so dass für diese das Bezugszeichen 146 verwendet wird.

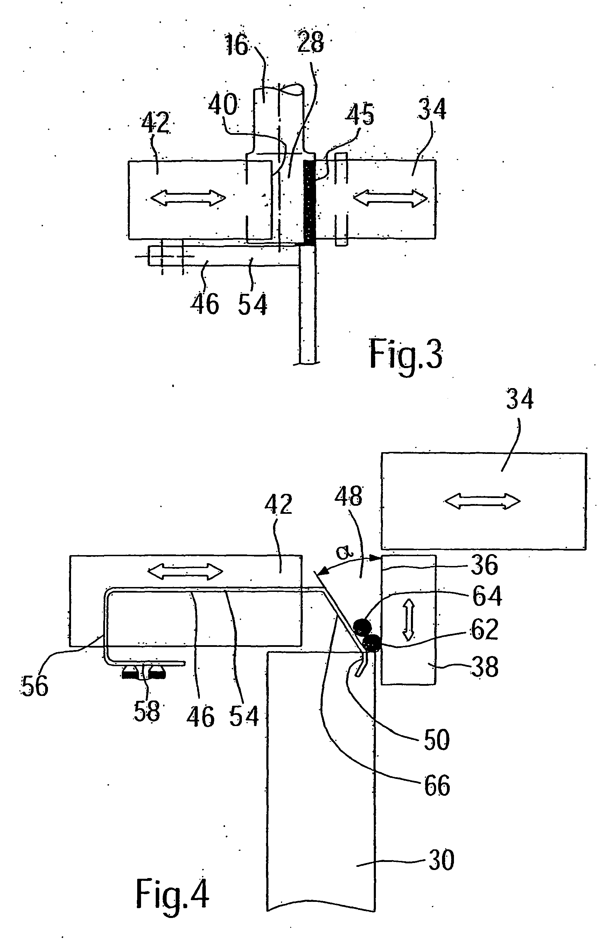

Um das Einlegen von Leitern 62, 64 in den Einlegeraum 48 zu erleichtern, ist in einer Weiterbildung der Erfindung gemäß Fig. 4 vorgesehen, dass der den Leit- oder Führungsschenkel bildende Außenschenkel 50 in seinem an dem Innenschenkel 54 angrenzenden Abschnitt 66 unter einem Winkel α geneigt zu der ersten Begrenzungsfläche 36 des Begrenzungselementes 38 verläuft. Ungeachtet der Schräge erfolgen Einbußen in der gewünschten ordnungsgemäßen Ausrichtung der Leiter 62, 64 nicht. Der Winkel α beläuft sich dabei vorzugsweise zwischen 15° und 60°.

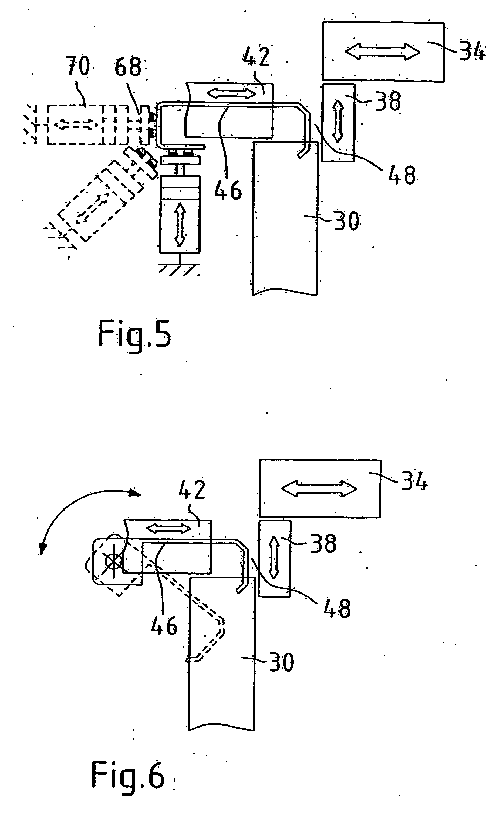

Um den Einlegeraum 48 auf eine gewünschte Breite B einzustellen bzw. die Einlegehilfe wie das Federblech 46 bei Nichtbedarf zu entfernen, sind gemäß der Fig. 5 - 7 verschiedene Lösungsmöglichkeiten gegeben.

So kann das Federblech 46 gemäß Fig. 5 mit einem Kolben 68 eines Zylinders 70 verbunden sein, um entsprechend der Darstellung gemäß der Fig. 5 durch Zurückziehen des Kolbens 68 aus dem von der Sonotrode bzw. dem Sonotrodenkopf 30, dem Begrenzungselement 38, der Gegenelektrode 34 und dem Seitenschieber 42 zu begrenzenden Verdichtungsraums entfernt zu werden. Dabei kann der Kolben 68 mit einem gewünschten Abschnitt des Federblechs 46 verbunden werden, ohne dass es eines näheren Eingehens bedarf.

Bei dem Ausführungsbeispiel der Fig. 5 ist das Federblech 46 verschwenkbar, um aus dem Bereich der zu verschweißenden Leiter, während diese verschweißt werden, entfemt zu werden, sei es zum Beispiel beim Verschweißen, sei es, wenn das Federblech 46 nicht benötigt bzw. erforderlich ist.

Auch besteht die Möglichkeit, das Federblech 46 mit dem Antrieb 71 eines nicht dargestellten Anschlags für den Seitenschieber 42 zu verbinden, durch den die Breite des die Leiter aufnehmenden Verdichtungsraums vorgegeben wird, also der Verstellweg 52 des Seitenschiebers 42 in Richtung des Begrenzungselementes 38 begrenzt wird. Durch diese Maßnahmen besteht die Möglichkeit, in Relation zu dem Anschlag die Breite des Einlegeraums 48 vorzugeben, da auch die Breite des Einlegeraums 38 - wie die des Verdichtungsraums 18 - auf die Anzahl bzw. den Querschnitt der zu verschweißenden Leiter eingestellt werden muss. Als Antrieb 41 kommt vorzugsweise ein Spindelantrieb in Frage, der mit einer entsprechenden von dem Federblech 46 ausgehenden Verzahnung 72 kämmt.

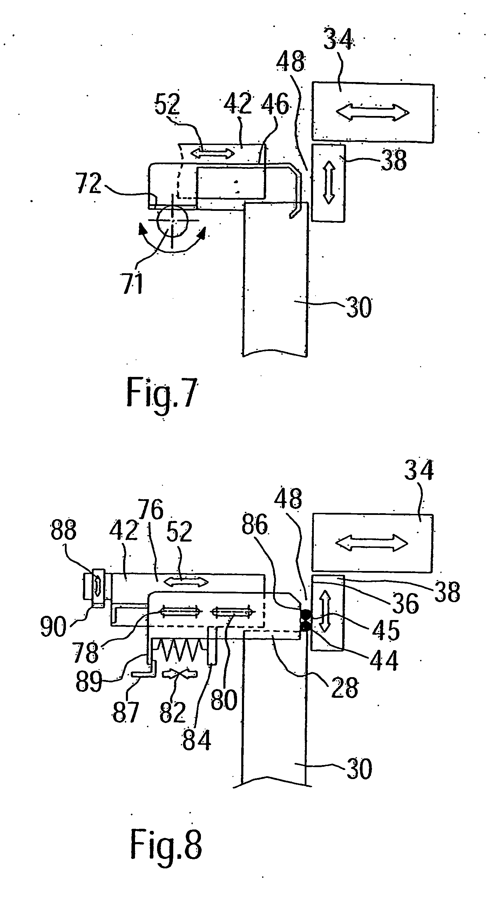

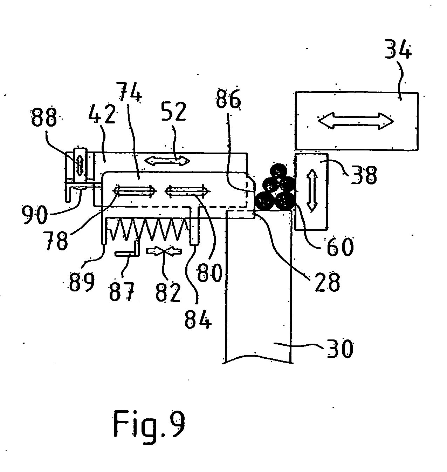

Eine andere Ausgestaltung des den Einlegeraum 48 in seiner Breite vorgebenden Leitelements ist den Fig. 8 und 9 zu entnehmen. Das Leitelement ist dabei als flächiges Führungselement wie Führungsblech 74 rechteckförmiger Geometrie ausgebildet, das eine Ebene aufspannt, die parallel zum Verstellweg 52 des Seitenschiebers 42 und senkrecht zu dem Abschnitt 28 des Sonotrodenkopfs 30 verläuft, auf dem einige der zu verschweißenden Leiter 44, 45, 60 aufliegen. Dabei ist das Führungsblech 74 an dem Seitenschieber 42, d.h. zumindest einer der entsprechend verlaufenden Außenflächen 76 befestigt, jedoch relativ zu dem Seitenschieber 42 verschiebbar. Dies wird durch parallel zum Verstellweg 42 verlaufende Langlöcher 78, 80 in dem Flührungsblech 74 und in die Langlöcher 78, 80 eingreifende von der Außenfläche 76 des Seitenschiebers 42 ausgehende Vorsprünge wie Stifte realisiert. Ferner ist das Führungsblech 74 im Ausführungsbeispiel über eine Zugfeder 82 mit einem in Bezug auf den Seitenschieber 42 ortsfesten Anschlag 84 verbunden, wodurch das Führungsblech 74 eine Kraftbeaufschlagung in Richtung des Begrenzungselementes 38 erfährt. Somit verläuft das Führungsblech 74 mit seinem im Ausführungsbeispiel vertikal verlaufenden Leit- oder FührungsAbschnitt 86 in Bezug auf das Begrenzungselement 38 vor der Begrenzungsfläche 40 des Seitenschiebers 42, so dass entsprechend der erfindungsgemäßen Lehre der Einlegeraum 48 auf den Querschnitt bzw. der Anzahl der Leiter 44 bei geöffnetem Verdichtungsraum einstellbar ist.

Um den Einlegeraum 48 auf eine unterschiedliche Anzahl von Leitern 60 bzw. auf unterschiedliche Gesamtquerschnitte einzustellen, ist ein auf die Breite des Einlegeraums 48 positionierbarer Anschlag 87 vorgesehen, in dessen Weg ein von dem Führungsblech abragender Vorsprung 89 verläuft, der dann an den Anschlag 87 zu liegen kommt (s.
Fig. 8), wenn die gewünschte Breite des Einlegeraums 48 vorliegt, also der für das gewünschte Ausrichten der Leiter 44, 45 erforderliche Abstand zwischen dem Führungsabschnitt 86 mit der ersten Begrenzungsfläche 36. Auch wenn bevorzugterweise der Anschlag 87 verstellbar ist, so kann dieser auch stationär in Bezug auf den Seitenschieber 42 und damit das Führungsblech 74 angeordnet sein. In diesem Fall ist der Anschlag 87 in Bezug auf den Abschnitt 89 des Führungsblechs 74 derart ausgerichtet, dass der Einlegeraum 48 eine Breite aufweist, die sicherstellt, dass bei Einlegen von zwei Leitern diese übereinander in dem Einlegeraum 48 anordbar sind.

Der Fig. 14 ist eine Weiterbildung der erfindungsgemäßen Lehre zu entnehmen, soweit die Ausführungsform der Fig. 8 und 9 betroffen ist. So besteht die Möglichkeit, das Führungsblech 74 mit einem Antrieb 92 zu verbinden, um im gewünschten Umfang eine Verstellung zu der ersten Begrenzungsfläche 36 vorzunehmen, also die Breite des Einlegeraums 48 einzustellen.

Um den Einlegeraum 48 zu vergrößern bzw. vollständig zu öffnen, sieht eine Weiterbildung vor, dass von dem Seitenschieber 42 ein Mitnehmer 88 ausgeht, der in eine von dem Führungsblech 74 ausgehende Aussparung 90 einrasten kann, so dass beim Zurückfahren des Seitenschiebers 42 unabhängig von der Kraftbeaufschlagung durch die Feder 82 das Führungsblech 74 mitgenommen, also der Einlegeraum 48 vergrößern wird. Das rastende Zusammenwirken von Seitenschieber 42 und Führungsblech 74 ist nicht erforderlich, wenn letzteres mit einem Antrieb verbunden ist.

Das Führungsblech 74 weist erwähntermaßen eine Rechteckgeometrie auf; wobei Längsschenkel 94, 96 parallel zum Verstellweg 52 des Seitenschiebers 42 verläuft. Die Längsschenkel 94, 96 gehen in den zu diesen vertikal verlaufenden Leitabschnitt 86 über, der im Übergangsbereich zum sonotrodenkopffernliegenden Längsschenkel 94 angeschrägt ist, um das Einlegen der Leiter 60 zu erleichtern.

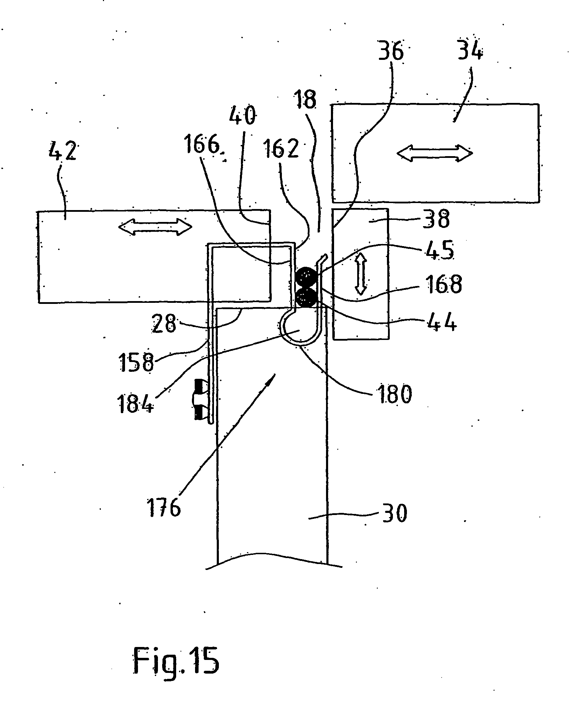

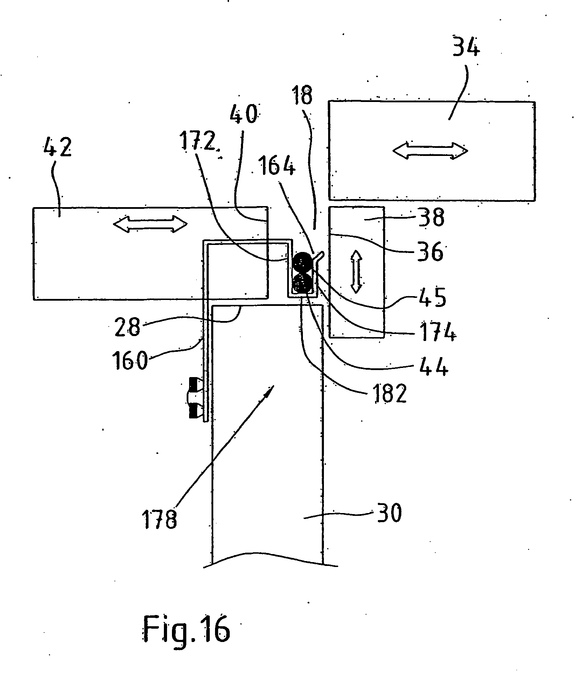

Den Fig. 15 und 16 sind weitere Ausgestaltungen von Leitelementen 158, 160 zu entnehmen, die gemäß der zuvor erläuterten Erfindung einen Verdichtungsraum einer Ultraschallschweißvorrichtung zugeordnet werden, so dass entsprechend für gleiche Elemente gleiche Bezugszeichen verwendet werden. Das jeweilige Leitelement 158, 160 für sich stellt einen Einlegeraum 162, 164 zur Verfügung, in dem im gewünschten Umfang die Leiter 44, 45 übereinander ausrichtbar sind, ohne dass der Verdichtungsraum 18 in seiner Breite entsprechend eingestellt sein muss. Vielmehr kann der Verdichtungsraum 18 geöffnet sein, also der Seitenschieber 42 von dem Begrenzungselement 36 zurückgezogen sein. Mit anderen Worten weist der Einlegeraum 162, 164 einen wirksamen Querschnitt, d. h. insbesondere eine Breite auf, die nicht nur kleiner als der wirksame Querschnitt des Verdichtungsraum 18 in geöffnetem Zustand ist, sondern entsprechend der erfindungsgemäßen Lehre sicherstellt, dass die Leiter 44, 45 zueinander ordnungsgemäß orientiert, also im Ausführungsbeispiel zu einer vertikal verlaufenden Reihe ausgerichtet sind. Dabei wird abweichend von den Ausführungsformen der Fig. 1 - 9 und 11 - 14 der Einlegeraum 162, 164 jeweils von einem Schenkel 166, 168 bzw. 170, 174 des Leitelements 158, 160 begrenzt. Die Schenkel 166, 168 bzw. 172, 174 erstrecken sich dabei entlang bzw. parallel oder in etwa parallel zu der ersten und zweiten Begrenzungsfläche 36 bzw. 40 des ersten Begrenzungselements 38 bzw. des Schiebers 42. Dabei bilden die Schenkel 166, 168 bzw. 172, 174 Seitenschenkel eines U-förmigen Abschnitts 176, 178 des vorzugsweise als Federblech ausgebildeten Leitelements 158, 160, wie die zeichnerischen Darstellungen verdeutlichen. Der jeweilige Querschenkel 180, 182 des U-förmigen Abschnitts 176, 178 kann dabei gemäß Fig. 15 unterhalb des den Verdichtungsraum 48 begrenzenden Abschnitts 28 des Sonotrodenkopfs 30 verlaufen und eine Geometrie eines O's bzw. offenen Kreises aufweisen. Somit bildet der Abschnitt 28 des Sonotrodenkopfs 30 Bodenfläche des Einlegeraums 162.

Nach dem Ausführungsbeispiel der Fig. 16 verläuft der Querschenkel 182 oberhalb des Abschnitts 28 des Sonotrodenkopfs 30 und bildet somit die Bodenfläche des Einlegeraums 164, auf der im Ausführungsbeispiel der Leiter 44 aufliegt.

Durch die entsprechende Konstruktion der Leitelemente 158, 160 besteht zusätzlich der Vorteil, dass zum Beispiel das Leitelement 158, 160 aus dem geöffneten Verdichtungsraum 148 herausbewegt werden kann, um zunächst ein ungehindertes Einlegen von Leitern zu ermöglichen. Dabei kann aufgrund der taschenförmigen Ausbildung des Querschenkels 180 des Leitelementes 158 ein Ausrichten der Leiter 44, 45 beim Absenken des Leitelementes 158 in den Verdichtungsraum 18 dann erfolgen, wenn der von dem Querschenkel 180 umgebene Raum 184 im Bereich unterhalb des Abschnitts 28 des Sonotrodenkopfs 30 abgesenkt wird, so dass hierdurch ein geführtes Ausrichten der Leiter 44, 45 zwischen dem Abschnitt 28 des Sonotrodenkopfs 30 und den Seitenschenkeln 166, 168 erfolgt. Eine diesbezügliche Konstruktion ist insbesondere dann von Vorteil, wenn der Abstand zwischen den Seitenschenkeln 166, 168 größer als jeweiliger Querschnitt von einzulegenden Leitern ist.

Um ein sicheres Führen beim Einlegen der Leiter in den Einlegeraum 48 sicherzustellen, können in den gegenüberliegenden Außenflächen 76 des Seitenschiebers 42 entsprechende eine Leit- bzw. Führungsfunktion ausübende Federbleche 48 bzw. Führungsbleche 74 angeordnet sein.

Besteht das Leit- oder Führungselement vorzugsweise aus Blechmaterial, so können geeignete andere Materialien gleichfalls verwendet werden, wobei für das gebogene Führungselement 48 die erforderliche Elastizität und für das flächige Element 74 die notwendige Eigensteifigkeit erfüllt sein müssen.

Ist die erfindungsgemäße Lehre anhand eines Verdichtungsraums erläutert worden, der von vier Elementen begrenzt ist, so ist auch eine Realisierung für solche Verdichtungsräume möglich, die durch eine andere Anzahl von Elementen begrenzt wird, wie zum Beispiel drei Elementen, um einen Knoten zu schweißen, der im Querschnitt eine Dreiecksgeometrie aufweist. In diesem Fall ist das Leitelement entsprechend zu den den Verdichtungsraum begrenzenden Elementen derart verstellbar, dass ein Einlegeraum zur Verfügung gestellt wird, mit dem die mit der erfindungsgemäßen Lehre erzielbaren Vorteile realisierbar sind, also die zu verdichtenden bzw. zu verschweißenden Leiter derart ordnungsgemäß zueinander ausgerichtet werden, dass diese beim Verschweißen in eine oder mehrere Reihen angeordnet sind.

## Patentansprüche

1. Anordnung zum Verschweißen von Werkstücken (44, 45, 60, 62, 64) wie elektrischen Leitern, insbesondere Litzen, mittels einer Ultraschallschweißvorrichtung (10) umfassend einen die Werkstücke aufnehmenden Verdichtungsraum (18), der zumindest von Abschnitten (28, 32) einer Ultraschallschwingungen übertragenden Sonotrode (16, 30) und einer Gegenelektrode (34) und einem eine insbesondere senkrecht zu den Abschnitten der Sonotrode und der Gegenelektrode sich erstreckende erste Begrenzungsfläche (36) aufweisenden Begrenzungselement (38) sowie einem zu der ersten Begrenzungsfläche verstellbaren eine zweite Begrenzungsfläche (40) aufweisenden Schieberelement (42) begrenzt ist, wobei die Werkstücke bei geöffnetem Verdichtungsraum in einen Einlegeraum (48) einbringbar sind, der vorzugsweise zumindest von den Abschnitten der Sonotrode und der ersten Begrenzungsfläche (36) des Begrenzungselements (38) begrenzt ist,
**dadurch gekennzeichnet,**
**dass** entweder der Einlegeraum (48) von Abschnitten (28, 32) der Sonotrode (16, 30) und des ersten Begrenzungselements (38) sowie von einem mit einem Leitabschnitt (50, 86) entlang der ersten Begrenzungsfläche des Begrenzungselements verlaufenden Leitelement (46, 74) begrenzt ist, wobei der Abstand B des Leitabschnitts des Leitelements zu der ersten Begrenzungsfläche kleiner als Abstand zwischen dieser und der zweiten Begrenzungsfläche (40) des Schieberelements (42) bei geöffnetem Verdichtungsraum (18) ist, oder dass der Einlegeraum von zwei Schenkeln (166, 168, 172, 174) eines Leitelements (158, 160) oder Abschnitten (176, 178) dieses begrenzt ist, die sich zumindest abschnittsweise entlang oder in etwa parallel zu sowohl der ersten Begrenzungsfläche als auch der zweiten Begrenzungsfläche (40) erstrecken, wobei wirksamer Abstand B zwischen den Schenkeln bzw. deren Abschnitten kleiner als Abstand zwischen der ersten und der zweiten Begrenzungsfläche bei geöffnetem Verdichtungsraum (18) ist.

2. Anordnung nach Anspruch 1,
**dadurch gekennzeichnet**
**dass** das Leitelement (46, 74, 158, 160) ein beim Schließen des Verdichtungsraums (18) wegbiegbares und/oder verstellbares Element ist.

3. Anordnung nach Anspruch 1 oder 2,
**dadurch gekennzeichnet,**
**dass** das Leitelement (46, 158, 160) ein Federelement, wie streifenförmiges Federblech ist.

4. Anordnung nach zumindest einem der vorhergehenden Ansprüche,
**dadurch gekennzeichnet,**
**dass** das Leitelement (46) ein zumindest zwei Schenkel (50; 54, 56, 58) aufweisendes gebogenes Federblech ist, wobei einer der Schenkel (54) sich zum Beispiel entlang Verstellweg (52) des Schieberelements (42) erstreckt und der andere Schenkel der sich entlang der ersten Begrenzungsfläche (36) erstreckende Leitabschnitt (50) des Leitelements ist.

5. Anordnung nach zumindest einem der vorhergehenden Ansprüche,
**dadurch gekennzeichnet,**
**dass** das Leitelement wie das Federblech (146) die Geometrie eines ungleichschenkligen U's aufweist, dessen längerer Schenkel (148) Halteschenkel des Leitelements ist.

6. Anordnung nach zumindest Anspruch 5,
**dadurch gekennzeichnet,**
**dass** das Leitelement (146) derart verbiegbar ist, dass der entlang der ersten Begrenzungsfläche (36) verlaufende Schenkel (152) einen im Querschnitt trapezartigen Einlegeraum (154) begrenzt.

7. Anordnung nach zumindest einem der vorhergehenden Ansprüche,
**dadurch gekennzeichnet,**
**dass** das Federblech (46) einen Halteschenkel (58), einen senkrecht zu diesem verlaufenden ersten Innenschenkel (56), den entlang des Verstellwegs (52) des Schieberelements (42) verlaufenden Schenkel als zweiten Innenschenkel (54) und den entlang der ersten Begrenzungsfläche (36) verlaufende Schenkel (50) als der Leitabschnitt umfasst.

8. Anordnung nach zumindest einem der vorhergehenden Ansprüche,
**dadurch gekennzeichnet,**
**dass** der Halteschenkel (58) und der erste und zweite Innenschenkel (56, 58) Geometrie eines ungleichschenkligen U's bilden.

9. Anordnung nach zumindest einem der vorhergehenden Ansprüche,
**dadurch gekennzeichnet,**
**dass** das gebogene Federblech die Geometrie eines offenen Vierecks aufweist.

10. Anordnung nach zumindest einem der vorhergehenden Ansprüche,
**dadurch gekennzeichnet,**
**dass** sich das Leitelement (46) entlang einer Außenfläche (76) des Schieberelements (42) erstreckt.

11. Anordnung nach zumindest einem der vorhergehenden Ansprüche,
**dadurch gekennzeichnet,**
**dass** sich der Leitabschnitt (50, 86) des Leitelements (46, 74) bei geöffnetem Verdichtungsraum (18) über eine Länge entlang der ersten Begrenzungsfläche (36) erstreckt, die größer als wirksame Länge der ersten Begrenzungsfläche bei geschlossenem Verdichtungsraum (18) ist.

12. Anordnung nach zumindest einem der vorhergehenden Ansprüche,
**dadurch gekennzeichnet,**
**dass** der Leitabschnitt (50) zumindest abschnittsweise unter einem Winkel a geneigt zu der ersten Begrenzungsfläche (36) verläuft.

13. Anordnung nach zumindest einem der vorhergehenden Ansprüche,
**dadurch gekennzeichnet,**
**dass** der geneigt zu der ersten Begrenzungsfläche (36) verlaufende Abschnitt (66) in den entlang des Verstellwegs (52) des Schieberelements (42) verlaufenden Schenkel (54) übergeht.

14. Anordnung nach zumindest einem der vorhergehenden Ansprüche,
**dadurch gekennzeichnet,**
**dass** der Neigungswinkel α sich beläuft auf vorzugsweise 15° ≤ α ≤ 60°.

15. Anordnung nach zumindest einem der vorhergehenden Ansprüche,
**dadurch gekennzeichnet,**
**dass** das Leitelement insbesondere in Form des Federblechs (46, 146) mit einem Antrieb (68, 70) wie Schrittmotor, Stellantrieb verbunden und über diesen verstellbar ist.

16. Anordnung nach zumindest einem der vorhergehenden Ansprüche, wobei der Verstellweg des Schieberelements (42) in Richtung der ersten Begrenzungsfläche (36) des Begrenzungselements (38) über einen Anschlag begrenzt ist, der über einen Antrieb (70) einstellbar ist,
**dadurch gekennzeichnet,**
**dass** das Leitelement (46, 146) mit dem Antrieb (70) oder einem gesonderten Antrieb verbunden ist.

17. Anordnung nach zumindest Anspruch 16,
**dadurch gekennzeichnet,**
**dass** der Antrieb (70) ein Spindelantrieb ist.

18. Anordnung nach zumindest Anspruch 1,
**dadurch gekennzeichnet,**
**dass** das Leitelement ein sich flächig entlang zumindest einer entlang des Verstellwegs (52) des Schieberelements (42) und senkrecht zu dem Abschnitt (28) der Sonotrode (16, 30) verlaufenden Außenfläche (76) erstreckendes flächiges Element (74) wie Blechelement ist, das parallel oder in etwa parallel zu der Außenfläche verläuft.

19. Anordnung nach zumindest Anspruch 18,
**dadurch gekennzeichnet,**
**dass** das Element (74) mit dem Schieberelement (42) verbunden und zu diesem verstellbar ist.

20. Anordnung nach zumindest einem der Ansprüche 18 und 19,
**dadurch gekennzeichnet,**
**dass** das Element (74) mit einem Federelement (82) verbunden ist, über das das Element relativ zu dem Schieberelement (42) in Richtung der ersten Begrenzungsfläche (36) verstellbar ist.

21. Anordnung nach zumindest einem der Ansprüche 18 bis 20,
**dadurch gekennzeichnet,**
**dass** das Element (74) zumindest ein parallel zu dem Verstellweg (52) verlaufendes Langloch aufweist, in das ein von dem Schieberelement (42) ausgehender Vorsprung wie Stift eingreift.

22. Anordnung nach zumindest einem der Ansprüche 18 bis 21,
**dadurch gekennzeichnet,**
**dass** das Element (74) zwei parallel zu dem Verstellweg (52) verlaufende Langlöcher (78, 80) aufweist, in die jeweils ein von dem Schieberelement (42) ausgehender Vorsprung eingreift.

23. Anordnung nach zumindest einem der Ansprüche 18 bis 22,
**dadurch gekennzeichnet,**
**dass** das Element (74) eine Rechteckform mit erstem und zweitem entlang des Verstellwegs (52) verlaufenden Längsschenkel (94, 96) und diese verbindenden sich entlang der ersten Begrenzungsfläche (36) verlaufenden den Leitabschnitt bildenden Querschenkel (86) aufweist.

24. Anordnung nach zumindest einem der Ansprüche 18 bis 23,
**dadurch gekennzeichnet,**
**dass** der Übergangsbereich zwischen dem Querschenkel (86) und sonotrodenfernliegendem Längsschenkel (94) des Elements (74) angeschrägt ist.

25. Anordnung nach zumindest Anspruch 1,
**dadurch gekennzeichnet**
**dass** entlang jeder senkrecht oder in etwa senkrecht zu dem Abschnitt der Sonotrode verlaufenden Außenfläche (76) des Schieberelements (42) ein Leitelement (46, 74, 146) verläuft.

26. Anordnung nach zumindest einem der Ansprüche 18 bis 25,
**dadurch gekennzeichnet,**
**dass** von dem Schieberelement (42) ein in das Element (74) oder in ein von diesem ausgehendes Element eingreifender Mitnehmer (88) zum Beabstanden des Elements zu der ersten Begrenzungsfläche (32) ausgeht.

27. Anordnung nach zumindest einem der Ansprüche 18 bis 26,
**dadurch gekennzeichnet,**
**dass** das flächige Element (74) über einen Antrieb (92) zu der ersten Begrenzungsfläche (32) verstellbar ist.

28. Anordnung nach zumindest Anspruch 1,
**dadurch gekennzeichnet,**
**dass** die den Einlegeraum (162, 164) seitlich begrenzenden Schenkel (166, 168, 172, 174) bzw, deren Abschnitte Seitenschenkel eines U-förmig gebogenen Abschnitts (176, 178) des vorzugsweise als Federelement wie streifenförmiges Federblech ausgebildeten Leitelements (158, 160) sind.

29. Anordnung nach Anspruch 28,
**dadurch gekennzeichnet,**
**dass** die Seitenschenkel verbindender Querschenkel (182) oberhalb des Abschnitts (28) der Sonotrode (16, 30) verläuft und Bodenbegrenzung des Einlegeraums (164) ist.

30. Anordnung nach Anspruch 28,
**dadurch gekennzeichnet,**
**dass** die Seitenschenkel verbindender Querschenkel (180) des U-förmig gebogenen Abschnitts (176) des Leitelements (158) unterhalb des Abschnitts (28) der Sonotrode (16, 30) verläuft, wobei der Abschnitt der Sonotrode Bodenbegrenzung des Einlegeraums (162) ist.

31. Anordnung nach Anspruch 30,
**dadurch gekennzeichnet,**
**dass** der unterhalb des Abschnitts (28) der Sonotrode (16, 30) verlaufende Querschenkel (180) eine Geometrie eines offenen O's aufweist.

## Claims

1. Arrangement for welding of workpieces (44, 45, 60, 62, 64), such as electrical conductors, especially strands, by means of an ultrasound welding device (10) comprising a compression chamber (18) receiving the workpieces, said compression chamber is bordered by at least sections (28, 32) of a sonotrode (16, 30) transmitting ultrasound vibrations and a counter electrode (34) and a border element (38), which has a first limiting surface (36) that runs, in particular, perpendicular to the sections of the sonotrode and the counter electrode, as well as a sliding element (42) with a second limiting surface (40) that is adjustable in relation to the first limiting surface, whereby the workpieces is, with the compression chamber open, insertable into an insertion space (48), which is preferably bordered by at least the sections of the sonotrode and the first limiting surface (36) of the border element (38),
**characterized in**
**that** either the insertion space (48) is bordered by sections (28, 32) of the sonotrode (16, 30) and the first border element (38), as well as by a guide element (46, 74) that runs with a guide section (50, 86) along the first limiting surface of the border element, whereby the distance B of the guide section of the guide element relative to the first limiting surface is smaller than distance between the latter and the second limiting surface (40) of the slide element (42) with the compression chamber (18) open, or that the insertion space is bordered by two legs (166, 168, 172, 174) of a guide element (158, 160), or sections (176, 178) thereof, which, at least in sections, extend along or approximately parallel to both the first limiting surface and the second limiting surface (40), whereby effective distance B between the legs, respectively their sections, is smaller than the distance between the first and second limiting surfaces with the compression chamber (18) open.

2. Arrangement according to claim 1,
**characterized in**
**that** the guide element (46, 74, 158, 160), when closing the compression chamber (18), is an element designed to be bent away and/or displaced.

3. Arrangement according to claim 1 or 2,
**characterized in**
**that** the guide element (46, 158, 160) is a spring element, such as a lamellar spring plate.

4. Arrangement according to at least one of the preceding claims,
**characterized in**
**that** the guide element (46) is a bent spring plate with at least two legs (50; 54, 56, 58), one of the legs (54) extending, for example, along the adjustment path (52) of the sliding element (42), and the other leg being the guide section (50) of the guide element that extends along the first limiting surface (36).

5. Arrangement according to at least one of the preceding claims,
**characterized in**
**that** the guide element such as spring plate (146) has the geometry of an unequal U, its longer leg (148) being holding leg of the guide element.

6. Arrangement according to at least claim 5,
**characterized in**
**that** the guide element (146) is bendable such that the leg (152) running along the first limiting surface (36) borders an insertion space (154) being trapezoid-like in cross section.

7. Arrangement according to at least one of the preceding claims,
**characterized in**
**that** the spring plate (46) comprises a holding leg (58), a first inner leg (56) that runs perpendicular to it, the leg that runs along the adjustment path (52) of the slide element (42) as a second inner leg (54) and the leg (50) running along the first limiting surface (36) as the guide section.

8. Arrangement according to at least one of the preceding claims,
**characterized in**
**that** the holding leg (58) and the first and second inner leg (56, 58) form geometry of an unequal U.

9. Arrangement according to at least one of the preceding claims,
**characterized in**
**that** the bent spring plate has the geometry of an open quadrangle.

10. Arrangement according to at least one of the preceding claims,
**characterized in**
**that** the guide element (46) extends along an outer surface (76) of the slide element (42).

11. Arrangement according to at least one of the preceding claims,
**characterized in**
**that**, with the compression chamber (18) open, he guide section (50, 86) of the guide element (46, 74) extends along a length of the first limiting surface (36) that is larger than the effective length of the first defining surface with the compression chamber (18) closed.

12. Arrangement according to at least one of the preceding claims,
**characterized in**
**that** the guide section (50) runs at least in sections at an angle α to the first limiting surface (36).

13. Arrangement according to at least one of the preceding claims,
**characterized in**
**that** the section (66) that runs inclined to the first limiting surface (36) passes into the leg (54) that runs along the adjustment path (52) of the slide element (42).

14. Arrangement according to at least one of the preceding claims,
**characterized in**
**that** the angle of inclination α preferably amounts 15° ≤ α ≤ 60°.

15. Arrangement according to at least one of the preceding claims,
**characterized in**
**that** the guide element, particularly in the form of the spring plate (46, 146), is connected with a drive (68, 70) such as a step motor, actuator, and is displaceable by this drive.

16. Arrangement according to at least one of the preceding claims, whereby the adjustment path of the sliding element (42) is bordered in the direction of the first limiting surface (36) of the defining element (38) by a catch, which is adjustable by means of an actuator (70),
**characterized in**
**that** the guide element (46, 146) is combined with the drive (70) or a separate drive.

17. Arrangement according to at least claim 16,
**characterized in**
**that** the drive (70) is a spindle drive.

18. Arrangement according to at least claim 1,
**characterized in**
**that** the guide element is a laminar element (74), such as a plate element, extending plane along at least one outer surface (76) running along the adjustment path (52) of the slide element (42) and perpendicular to the section (28) of the sonotrode (16, 30), whereby said laminar element runs parallel or approximately parallel to the outer surface.

19. Arrangement according to at least claim 18,
**characterized in**
**that** the element (74) is combined with the sliding element (42) and adjustable in relation to it.

20. Arrangement according to at least on of claims 18 and 19,
**characterized in**
**that** the element (74) is combined with a spring element (82), by means of which the element is adjustable relative to the sliding element (42) in the direction of the first limiting surface (36).

21. Arrangement according to at least one of claims 18 to 20,
**characterized in**
**that** the element (74) has at least one slot running parallel to the adjustment path (52), into which a protrusion from the slide element (42), such as a pin, meshes.

22. Arrangement according to at least one of claims 18 to 21,
**characterized in**
**that** the element (74) has two slots (78, 80) running parallel to the adjustment path (52), into each of which a protrusion originating from the slide element (42) meshes.

23. Arrangement according to at least one of claims 18 to 22,
**characterized in**
**that** the element (74) has a rectangular form with first and second longitudinal legs (94, 96) that run along the adjustment path (52), and transverse legs (86) connecting them, running along the first limiting surface (36) and forming the guide section.

24. Arrangement according to at least one of claims 18 to 23,
**characterized in**
**that** the transition region between the transverse leg (86) and the longitudinal leg (94) of the element (74) that lies further away from the sonotrode is slanted.

25. Arrangement according to at least claim 1,
**characterized in**
**that** a guide element (46, 74, 146) runs along each outer surface (76) of the slide element (42) that runs perpendicular or approximately perpendicular to the section of the sonotrode.

26. Arrangement according to at least one of claims 18 to 25,
**characterized in**
**that** an engaging piece (88) originating from the slide element (42) meshes into the element (74) or an element originating from it, in order to keep the element at a distance from the first defining surface (32).

27. Arrangement according to at least one of claims 18 to 26,
**characterized in**
**that** the laminar element (74) is adjustable to the first limiting surface (32) by means of a drive (92).

28. Arrangement according to at least claim 1,
**characterized in**
**that** the legs (166, 168, 172, 174), respectively their sections, that limit the insertion space (162, 164) are side legs of a U-shaped arched section (176, 178) of the guide element (158, 160), which is preferably configured as a spring element such as laminar spring plate.

29. Arrangement according to claim 28,
**characterized in**
**that** the transverse leg (182) connecting the side legs runs above the section (28) of the sonotrode (16, 30) and limits the floor of the insertion space (164).

30. Arrangement according to claim 28,
**characterized in**
**that** the transverse leg (180), which connects the side legs, of the U-shaped arched section (176) of the guide element (158) runs below the section (28) of the sonotrode (16, 30), with the section of the sonotrode limiting the floor of the insertion space (162).

31. Arrangement according to claim 30,
**characterized in**
**that** the transverse leg (180) running below the section (28) of the sonotrode (16, 30) has the geometry of an open "O."

## Revendications

1. Système pour souder des pièces d'oeuvre (44, 45, 60, 62, 64) telles que des conducteurs électriques, en particulier des fils toronnés, au moyen d'une soudeuse à ultrasons (10), comprenant une chambre de compression (18) logeant les pièces d'oeuvre, qui est limitée par au moins des sections (28, 32) d'une sonotrode (16, 30) transmettant des vibrations ultrasonores et d'une contrélectrode (34), et par un élément de délimitation (38) présentant une première face de délimitation (36) s'étendant en particulier perpendiculairement aux sections de la sonotrode et de la contrélectrode ainsi que par un coulisseau (42) présentant une deuxième face de délimitation (40) réglable par rapport à la première face de délimitation, sachant que, lorsque la chambre de compression est ouverte, les pièces d'oeuvre peuvent être placées dans une chambre d'insertion (48) qui est de préférence limitée au moins par les sections de la sonotrode et par la première face de délimitation (36) de l'élément de délimitation (38),
**caractérisé en ce**
**qu'**ou bien la chambre d'insertion (48) est limitée par des sections (28, 32) de la sonotrode (16, 30) et du premier élément de délimitation (38) ainsi que par un élément conducteur (46, 74) s'étendant le long de la première face de délimitation de l'élément de délimitation avec une section conductrice (50, 86), sachant que la distance B de la section conductrice de l'élément conducteur à la première face de délimitation est inférieure à la distance entre celle-ci et la deuxième face de délimitation (40) du coulisseau (42) lors que la chambre de compression (18) est ouverte, ou qu'ou bien la chambre d'insertion est limitée par deux branches (166, 168, 172, 174) d'un élément conducteur (158, 160) ou par des sections (176, 178) de celui-ci qui s'étendent au moins sectoriellement ou approximativement parallèlement à la première face de délimitation ainsi qu'à la deuxième face de délimitation (40), sachant que la distance utile B entre les branches ou leurs sections est inférieure à la distance entre les première et deuxième faces de délimitation lorsque la chambre de compression (18) est ouverte.

2. Dispositif selon la revendication 1,
**caractérisé en ce**
**que** l'élément conducteur (46, 74, 158, 160) est un élément qui peut être écarté par flexion et/ou déplacé à la fermeture de la chambre de compression (18).

3. Dispositif selon la revendication 1 ou 2,
**caractérisé en ce**
**que** l'élément conducteur (46, 158, 160) est un élément élastique tel qu'une tôle élastique en forme de lame.

4. Dispositif selon au moins l'une des revendications précédentes,
**caractérisé en ce**
**que** l'élément conducteur (46) est une tôle élastique coudée présentant au moins deux branches (50 ; 54, 56, 58), sachant qu'une des branches (54) s'étend par exemple le long de la plage de réglage (52) du coulisseau (42) et que l'autre branche est la section conductrice (50) de l'élément conducteur qui s'étend le long de la première face de délimitation (36).

5. Dispositif selon au moins l'une des revendications précédentes,
**caractérisé en ce**
**que** l'élément conducteur tel que la tôle élastique (146) présente la géométrie d'un U à branches inégales, dont la longue branche (148) est la branche de fixation de l'élément conducteur.

6. Dispositif selon au moins la revendication 5,
**caractérisé en ce**
**que** l'élément conducteur (146) est déformable de manière telle que la branche (152) s'étendant le long de la première face de délimitation (36) délimite une chambre d'insertion (154) de section trapézoïdale.

7. Dispositif selon au moins l'une des revendications précédentes,
**caractérisé en ce**
**que** la tôle élastique (46) comprend une branche de fixation (58), une première branche intérieure (56) perpendiculaire à celle-ci, la branche s'étendant le long de la plage de réglage (52) du coulisseau (42) comme deuxième branche intérieure (54), et la branche (50) s'étendant le long de la première face de délimitation (36) comme section conductrice.

8. Dispositif selon au moins l'une des revendications précédentes,
**caractérisé en ce**
**que** la branche de fixation (58) ainsi que la première et la deuxième branches intérieures (56, 58) ont la géométrie d'un U à branches inégales.

9. Dispositif selon au moins l'une des revendications précédentes,
**caractérisé en ce**
**que** la tôle élastique coudée présente la géométrie d'un quadrilatère ouvert.

10. Dispositif selon au moins l'une des revendications précédentes,
**caractérisé en ce**
**que** l'élément conducteur (46) s'étend le long d'une face extérieure (76) du coulisseau (42).

11. Dispositif selon au moins l'une des revendications précédentes,
**caractérisé en ce**
**que**, lorsque la chambre de compression (18) est ouverte, la section conductrice (50, 86) de l'élément conducteur (46, 74) s'étend le long de la première face de délimitation (36) sur une longueur supérieure à la longueur utile de la première face de délimitation lorsque la chambre de compression (18) est fermée.

12. Dispositif selon au moins l'une des revendications précédentes,
**caractérisé en ce**
**que** la section conductrice (50) s'étend au moins sectoriellement de manière inclinée sous un angle α par rapport à la première face de délimitation (36).

13. Dispositif selon au moins l'une des revendications précédentes,
**caractérisé en ce**
**que** la section (66) inclinée par rapport à la première face de délimitation (36) se raccorde à la branche (54) s'étendant le long de la plage de réglage (52) du coulisseau (42).

14. Dispositif selon au moins l'une des revendications précédentes,
**caractérisé en ce**
**que** l'angle d'inclinaison α est de préférence tel que 15° ≤ α ≤ 60°.

15. Dispositif selon au moins l'une des revendications précédentes,
**caractérisé en ce**
**que** l'élément conducteur en particulier sous forme de la tôle élastique (46, 146) est relié à un entraînement (68, 70) tel qu'un moteur pas à pas, un servomoteur, et est réglable au moyen de celui-ci.

16. Dispositif selon au moins l'une des revendications précédentes, sachant que la plage de réglage du coulisseau (42) en direction de la première face de délimitation (36) de l'élément de délimitation (38) est limitée par une butée réglable par un entraînement (70),
**caractérisé en ce**
**que** l'élément conducteur (46, 146) est relié à l'entraînement (70) ou à un entraînement distinct.

17. Dispositif selon au moins la revendication 16,
**caractérisé en ce**
**que** l'entraînement (70) est un entraînement à broche.

18. Dispositif selon au moins la revendication 1,
**caractérisé en ce**
**que** l'élément conducteur est un élément (74) tel qu'un élément en tôle parallèle ou approximativement parallèle à la face extérieure et qui s'étend en nappe le long d'au moins une face extérieure (76) s'étendant le long de la plage de réglage (52) du coulisseau (42) et perpendiculairement à la section (28) de la sonotrode (16, 30).

19. Dispositif selon au moins la revendication 18,
**caractérisé en ce**
**que** l'élément (74) et relié au coulisseau (42) et réglable par rapport à celui-ci.

20. Dispositif selon au moins l'une des revendications 18 et 19,
**caractérisé en ce**
**que** l'élément (74) est relié à un élément élastique (82), par l'intermédiaire duquel l'élément est réglable par rapport au coulisseau (42) en direction de la première face de délimitation (36).

21. Dispositif selon au moins l'une des revendications 18 à 20,
**caractérisé en ce**
**que** l'élément (74) présente au moins un trou oblong s'étendant parallèlement à la plage de réglage (52), et dans lequel s'engage une partie en saillie telle qu'une tige partant du coulisseau (42).

22. Dispositif selon au moins l'une des revendications 18 à 21,
**caractérisé en ce**
**que** l'élément (74) présente deux trous oblongs (78, 80) s'étendant parallèlement à la plage de réglage (52), dans chacun lesquels s'engage une partie en saillie partant du coulisseau (42).

23. Dispositif selon au moins l'une des revendications 18 à 22,
**caractérisé en ce**
**que** l'élément (74) présente une forme rectangulaire avec une première et une seconde branches longitudinales (94, 96) s'étendant le long de la plage de réglage (52), et une branche transversale (86) qui les relie et forme la section conductrice s'étendant le long de la première face de délimitation (36).

24. Dispositif selon au moins l'une des revendications 18 à 23,
**caractérisé en ce**
**que** la zone de transition entre la branche transversale (86) et la branche longitudinale (94) de l'élément (74) éloignée de la sonotrode est chanfreinée.

25. Dispositif selon au moins la revendication 1,
**caractérisé en ce**
**qu'**un élément conducteur (46, 74, 146) s'étend le long de chaque face extérieure (76) du coulisseau (42) perpendiculairement ou approximativement perpendiculairement à la section de la sonotrode.

26. Dispositif selon au moins l'une des revendications 18 à 25,
**caractérisé en ce**
**que** du coulisseau (42) part un entraîneur (88) s'engageant dans l'élément (74) ou dans un élément partant de ce dernier afin de maintenir l'élément à distance de la première face de délimitation (32).

27. Dispositif selon au moins l'une des revendications 18 à 26,
**caractérisé en ce**
**que** l'élément plan (74) est réglable par rapport à la première face de délimitation (32) par l'intermédiaire d'un entraînement (92).

28. Dispositif selon au moins la revendication 1,
**caractérisé en ce**
**que** les branches (166, 168, 172, 174) ou leurs sections limitant latéralement la chambre d'insertion (162, 164), sont des branches latérales d'une section coudée en forme de U (176, 178) de l'élément conducteur (158, 160) formé de préférence comme élément élastique tel qu'une tôle élastique en forme de lame.

29. Dispositif selon la revendication 28,
**caractérisé en ce**
**que** la branche transversale (182) reliant les branches latérales s'étend au-dessus de la section (28) de la sonotrode (16, 30) et est la délimitation inférieure de la chambre d'insertion (164).

30. Dispositif selon la revendication 28,
**caractérisé en ce**
**que** la branche transversale (180) de la section coudée en forme de U (176) de l'élément conducteurs (158) et reliant les branches latérales s'étend au-dessous de la section (28) de la sonotrode (16, 30), la section de la sonotrode étant la délimitation inférieure de la chambre d'insertion (162).

31. Dispositif selon la revendication 30,
**caractérisé en ce**
**que** la branche transversale (180) s'étendant sous la section (28) de la sonotrode (16, 30) présente une géométrie d'un O ouvert.
